Europäisches Patentamt

European Patent Office

Office européen des brevets

(11) Publication number: **0 019 355**
**B1**

(12) **EUROPEAN PATENT SPECIFICATION**

(45) Date of publication of patent specification: **28.03.84**

(21) Application number: **80301150.1**

(22) Date of filing: **10.04.80**

(51) Int. Cl.³: **H 01 L 29/08,**
**H 01 L 29/72, H 01 L 27/06**

(54) **Transistor structure.**

(30) Priority: **11.04.79 JP 43967/79**

(43) Date of publication of application:
**26.11.80 Bulletin 80/24**

(45) Publication of the grant of the patent:
**28.03.84 Bulletin 84/13**

(84) Designated Contracting States:
**DE FR GB NL**

(56) References cited:
**DE - A - 2 241 306**
**DE - A - 2 332 144**
**FR - A - 2 314 582**
**FR - A - 2 374 743**
**US - A - 4 038 680**

**SOLID STATE ELECTRONICS, vol. 13, July 1970,
London, GB D. KASPERKOVITZ: "The hook-
emitter transistor: a proposed amplifier with
high gain-bandwidth product", pages 1025—1031**

(73) Proprietor: **FUJITSU LIMITED**
**1015, Kamikodanaka Nakahara-ku**
**Kawasaki-shi Kanagawa 211 (JP)**

(72) Inventor: **Nawata, Yoshiaki**
**2-1-25-501, Yohkohdai**
**Isogo-ku Yokohama-shi Kanagawa 235 (JP)**
Inventor: **Nakatani, Yasutaka**
**15-2, Moegino**
**Midori-ku Yokohama-shi Kanagawa 227 (JP)**
Inventor: **Nakazawa, Haruki**
**3193, Nogawa**
**Takatsu-ku Kawasaki-shi Kanagawa 213 (JP)**

(74) Representative: **Overbury, Richard Douglas et al,**
**HASELTINE LAKE & CO Hazlitt House 28**
**Southampton Buildings Chancery Lane**
**London WC2A 1AT (GB)**

(56) References cited:
**ELECTRONIC DESIGN, vol. 27, no. 7, March 29,
1979 Rochelle Park US D. BAUGHER: "To pick
the right power semiconductor, understand
device processing methods", pages 142-147**

Courier Press, Leamington Spa, England.

# Transistor structure

This invention relates to transistor structures.

Transistors which are capable of operating at high frequencies and at high output powers by connecting in parallel a plurality of transistor units, each for handling low level signals, formed on a semiconductor substrate, have been proposed.

Examples of such transistors are the overlay type transistor (see U.S. patent No. 3,434,091), and the ring-emitter type transistor (see U.S. patent No. 4,157,561) which have already been developed and put into practical use.

In the structure of such a transistor, a base (lead out) electrode and an emitter (lead out) electrode formed on an insulation film of, for example, silicon dioxide ($SiO_2$), formed on the semiconductor substrate, are extensively disposed in the form of the teeth of a comb so that the lead out electrode can connect to each individual isolated transistor unit.

If the insulation film has a pinhole flaw therein or part of the film is missing, the base and emitter are likely to be shorted. When the width of an electrode or the number of electrodes (or electrode teeth) is increased in order to convey a higher power, probability of short circuiting naturally increases.

The occurrence of such shorts or short circuits of base and emitter can reduce the manufacturing yield of usable transistors and can reduce transistor reliability.

Further, the individual transistor units formed on a semiconductor substrate, which units together constitute such a transistor, do not always have the same electric characteristics, and when such a transistor operates, it is possible for a particular transistor unit to undergo secondary breakdown due to an excessive load applied thereto as a result of irregularity in the characteristics of the other transistor units.

In transistors of this type it would therefore be desirable to insert stabilizing resistors into the emitter circuits of the transistor units in order to equalize the loads applied to the transistor units by means of a negative feedback effect provided by the stabilizing resistors.

For the insertion of stabilizing resistors various means have already been proposed.

In one method it is proposed to use as stabilizing resistor materials a metallic substance, such as nichrome (Ni-Cr) for example, or a polycrystalline semiconductor substance such as polycrystalline silicon. Such resistor materials may be deposited and laminated in an electrode window provided in the insulating film covering the emitter region of a transistor unit and then one end of the electrode wiring connected to the resistor material (so that the resistor material is between the electrode wiring and the emitter region of the transistor unit). Alternatively the resistor material can be inserted and connected on the insulating film in the midst of electrode wiring, part of which extends up onto the insulating film from an electrode window provided in the insulating film covering the emitter region.

In another method, a diffusion region which is formed in the base region with the same conductivity type as the emitter region, simultaneously with the formation of the emitter region or in a process separate from that by which the emitter region is formed, is used as a stabilizing resistor. Such a diffusion resistor may be formed in such a way as to come into contact at one end thereof with the emitter region and so that the other end thereof is connected to electrode wiring. Otherwise the diffusion resistor may be formed in isolation at a distance from the corresponding emitter region with one end of the resistor connected to the emitter region by way of electrode wiring and the other end lead out by way of further electrode wiring.

However such methods have, in general, disadvantages such as a requirement for an increased number of manufacturing processes or steps, inability to provide sufficiently good electrical characteristics, and inability to provide high integration density.

For example, in a case in which a metallic substance or a polycrystalline semiconductor substance is used as a resistor material, processes for depositing these materials and forming it into the desired pattern are inevitably required with a resultant direct increase in the number of manufacturing processes. In addition, attempts to increase the number of emitters in order to obtain higher output power make it difficult to pattern the resistor material suitably and can result in a loss in integration density and an increase in the physical dimensions of a semiconductor element (chip size).

Moreover, difficulties in selecting a material which simultaneously satisfies ohmic value requirements and current capacity requirements has militated against practical realization of such transistors with stabilizing resistors.

In a case in which a diffusion region wherein an impurity of the same conductivity type as the emitter region is diffused into a base region to provide a stabilizing resistor, carrier injection occurs from the diffusion resistance to the base region during operation of a transistor and thereby current amplification factor ($h_{FE}$) of the transistor is reduced. Further, attempts to form emitter regions and the diffusion resistors in different diffusion processes will naturally cause an increase in the number of manufacturing steps.

DE—A—2 241 306 discloses a transistor structure having a collector region of one conductivity type and a base region of the opposite conductivity type. A two-conductivity emitter structure is provided. This emitter structure is disclosed in U.S.—A—3427511. In this structure an emitter is formed in the base region. The emitter has a central diffused portion of relatively high sheet resistance. Surrounding this portion of high sheet resistance is an annular portion of relatively high conductivity which constitutes the active emitter portion. The highly resistive central portion acts as a ballast resistor in series with the actively emitting portion to prevent high current concentrations. The highly resistive central portion and the relatively high conductivity annular portion are of the one conductivity type. In the transistor structure of DE—A—2241306 an additional region, of the opposite conductivity type, is formed in the highly resistive central, ballast resistor, portion. An emitter contact is connected to the highly resistive central portion and the additional region and current flows between the emitter contact and the active emitter portion by way of the highly resistive central portion and the additional region.

US—A—4 072 979 (which corresponds to FR—A—2 314 582) discloses an integrated power amplifier composed of a multiplicity of elemental transistors. The elemental transistors are provided in an array of parallel rows and a metallic emitter lead is disposed along the centre line of a row between symmetrical sets of emitter areas. A pair of such emitter areas—of one conductivity type—form part of each elemental transistor (which also possesses a base—of the opposite conductivity type—and a collector—of the one conductivity type) and are linked to the emitter lead by narrow conductive zones, which constitute emitter resistors, between the emitter areas of the pair. Neighbouring elemental transistors—and their emitter areas—are separated by highly resistive intrinsic regions. A transistor structure disclosed in US—A—4072 979 has collectors, of one conductivity type, a base layer of the opposite conductivity type, a central zone of emitter material, and lateral active emitter areas of the one conductivity type which narrow rectangular zones of limited conductivity, which provide emitter resistors, link to the central zone.

According to the present invention there is provided a transistor structure having a collector region of a first conductivity type, a base region of a second, opposite, conductivity type, an emitter zone of the first conductivity type, and an additional region of the second conductivity type formed in the emitter zone, with a stabilising resistor connected between an emitter lead-out electrode and an active emitter region, characterised in that the additional region is used as the stabilizing resistor and in that the additional region is arranged to divide the emitter zone into a plurality of active emitter regions that are isolated thereby from one another, due to resistance generated as a result of the reduction of the cross section of the emitter zone by the additional region.

According to another aspect of the present invention there is provided a transistor structure having a collector region of a first conductivity type, a base region of a second, opposite, conductivity type, an emitter zone of the first conductivity type, and an additional region of the second conductivity type formed in the emitter zone, with a stabilizing resistor connected between an emitter lead-out electrode and an active emitter region, characterised in that the additional region is arranged to divide the emitter zone into a plurality of active emitter regions that are isolated thereby from one another due to resistance generated as a result of the reduction of the cross section of the emitter zone by the additional region, and in that a respective stabilising resistor is provided in respect of each active emitter region, each stabilising resistor being a further region provided in the relevant active emitter region, or being provided on the relevant active emitter region.

According to the present invention there is also provided a transistor structure having a collector region of a first conductivity type, a base region of a second, opposite, conductivity type, a stripe-like emitter zone of the first conductivity type, and a further zone, of the first conductivity type, contiguous with the emitter zone, a stabilising resistor being formed in the region linking the contiguous emitter zone and further zone and being connected between the stripe-like emitter zone and an emitter lead-out electrode, characterised in that the stabilising resistor consists of a region of the second conductivity type, and is arranged to isolate the stripe-like emitter zone from the contiguous further zone, due to resistance generated as a result of the reduction, by the region, of the cross section of the region linking the emitter zone and the further zone.

Embodiments of this invention can provide a transistor structure in which the disadvantages of transistors having the previously proposed structures mentioned above can be avoided and which can be fabricated with a sufficiently high manufacturing yield.

Moreover, a transistor embodying this invention can offer excellent high frequency and high output power characteristics.

Reference is made, by way of example, to the accompanying drawings in which:—

Fig. 1 illustrates the structure of a transistor for assistance in explanation of an embodiment of the present invention; (a) is a plan view, (b) is a cross-sectional view taken along the line X—X' of (a), and (c) is a cross-sectional view taken along the line Y—Y' of (a);

Fig. 2 is a plan view which illustrates the structure of a transistor for assistance in explanation of another embodiment of the present invention;

Fig. 3 is a plan view which illustrates the structure of a transistor for assistance in explanation of a further embodiment of the present invention;

Fig. 4 is a plan view which illustrates the structure of a transistor embodying the present invention;

Fig. 5 is a plan view which illustrates the structure of another transistor embodying the present invention;

Fig. 6 illustrates the structure of a further transistor embodying the present invention; (a) is a plan view, (b) is a cross-sectional view taken along the line X—X' of (a) and (c) is a cross-sectional view taken along the line Y—Y' of (a);

Fig. 7 comprises schematic plan views (a) and (b) which illustrate the structures for assistance in explanation of further transistors in accordance with the present invention;

Fig. 8 illustrates the structure of a transistor in accordance with another embodiment of the present invention; (a) is a plan view and (b) is a cross-sectional view taken along the line X—X' of (a); and

Fig. 9 is a plan view of a transistor chip embodying the present invention.

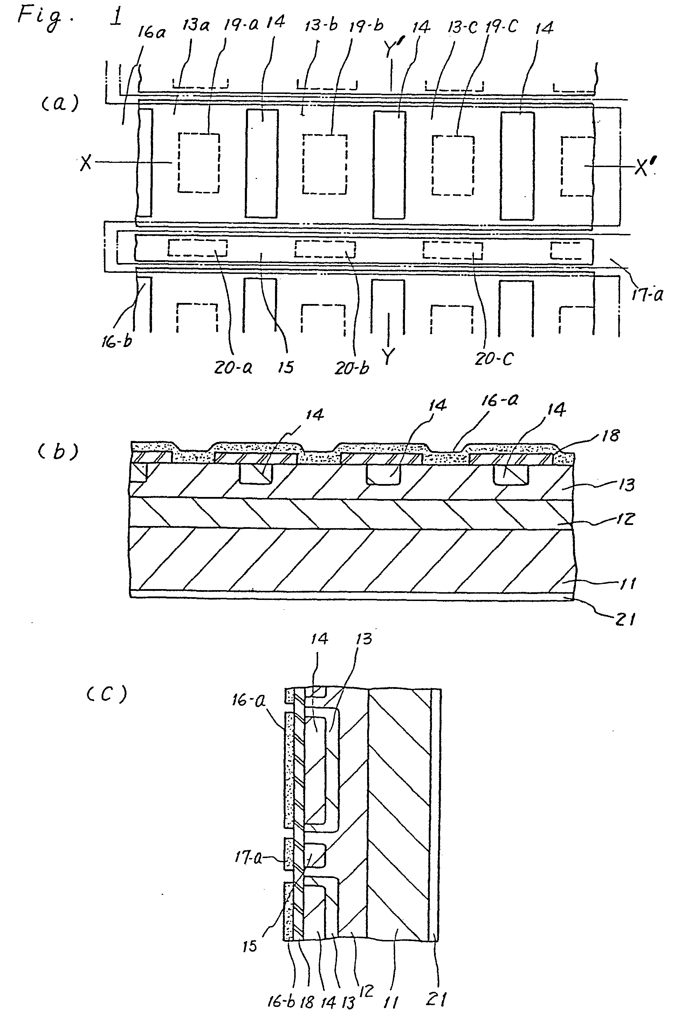

Figure 1 illustrates transistor structure for assistance in explanation of an embodiment of this invention. Figure 1(a) is a plan view of the structure, (b) is a cross-sectional view taken along the line X—X' of (a) and (c) is a cross-sectional view taken along the line Y—Y' of (a).

In Figure 1, 11 is a collector region having a structure for example comprising an N type epitaxial layer formed on an $N^+$ type semiconductor substrate, for example an $N^+$ type silicon (Si) substrate. 12 is a P-type base region formed on a surface of the collector region 11; 13 is an $N^+$ type emitter region formed in the base region 12 (see (c) particularly). Each emitter region is in the form of a stripe. Together, a number of regions 13 may be likened to the teeth of a comb. 14 is a $P^+$ type isolation region formed in the emitter region 13; 15 is a $P^+$ type base contact region. The base contact region 15, as best seen in (a), is formed in the base region 12, and extends along region 12 between emitter regions 13 and parallel thereto.

16a and 16b are emitter lead-out electrodes (seen in section in (c) and indicated by chain lines in (a). In (b) only 16a can be seen in section). The lead-out electrodes 16a and 16b extend over respective stripe like emitter regions 13.

17a is a base lead-out electrode (see in section in (c) and indicated by a chain line in (a)). The lead out electrode 17a extends over the base contact region 15.

18 is an insulating film covering a semiconductor substrate surface. 19a, 19b, 19c ... are emitter lead-out electrode connecting windows which are formed in the insulating film 18. 20a, 20b, 20c, ... are base lead-out electrode connecting windows formed in the insulating film 18. 21 is a collector electrode.

A transistor structure employed in some embodiments of this invention resembles that shown in Fig. 1 in that a stripe-like emitter region 13 is divided into a number of small active emitter regions 13a, 13b, ... by isolation regions 14 which, as best seen in (a), are disposed so as to lie across the emitter region 13 in directions orthogonal to the elongate direction (the stripe direction) of region 13. Each small active emitter region 13a, 13b, etc. is generally rectangular in shape. In this case the isolation regions 14 do not divide the stripe-like emitter region 13 into small active emitter regions by a process such that they contact the base region 12 by extending completely across the stripe emitter region 13 and/or by extending completely through the depth of emitter region 13. Rather, the isolation regions 14 are disposed in the stripe emitter region 13 in the form of lands so that the cross section of the emitter region 13 is reduced to the sides (upper and/or lower sides as seen in (a) and (c)) of the isolation regions 14 considered along the direction of the emitter region stripe. The cross section of the emitter region is also reduced in depth, under the isolation region, as best seen in (c). Thus the emitter region 13 is divided into small emitter regions 13a, 13b, ... due to resistance generated as a result of the reduction of cross section thereof by the isolation regions.

The respective isolated small emitter regions 13a, 13b, ... respectively provide transistor operation over emitter-base junction areas near to the respective adjacent base contact regions 15. A small emitter region, the base region which contacts the small emitter region and the collector region under the base region form a transistor unit.

Thus, a single stripe emitter region 13 is so structured as to provide a plurality of small emitter regions which are connected in parallel with one another by an emitter lead-out electrode.

Moreover, a plurality of stripe emitter regions can themselves be connected in parallel, and a transistor structure embodying this invention can have a structure which is suited for giving high frequency and high output power characteristics.

Thus a plurality of small emitter regions are provided in the form of a matrix of emitter regions.

In a transistor structure as described above with reference to Fig. 1, the emitter lead-out electrodes 16 which are disposed on and extended over stripe emitter regions 13 and which connect in parallel the pluralities of small emitter regions formed in the stripe emitter regions via lead-out electrode connecting windows are such that they connect the small emitter regions in parallel without being disposed on the base region. Therefore, if pinholes exist in the insulating film 18 the emitter lead-out electrodes 16 can be connected through the pinholes to the isolation regions 14, but not to the base region and short circuits can therefore occur only between the isolation regions 14 and the emitter region and cannot lead to a short between the emitter region and base region since the isolation regions 14 are isolated and insulated from the base region by the emitter region itself and are set in a floating condition from the electrical viewpoint when in operation. Thus, problems of reduction in the manufacturing yield and in reliability due to pinholes in the insulating film under an emitter lead-out electrode can be avoided.

Moreover, an emitter lead-out electrode can be formed to extend over almost all of the width of a single stripe emitter region, offering an increase in effective electrode cross section, and this transistor structure can effectively provide for a high output power by increasing the number of transistor units formed in a stripe emitter region.

Since the isolation regions 14 can be formed simultaneously with regions constituting stabilizing resistors, and/or base contact regions, by a diffusion method as will be explained later, the number of manufacturing steps needed to form the transistor structure is not increased.

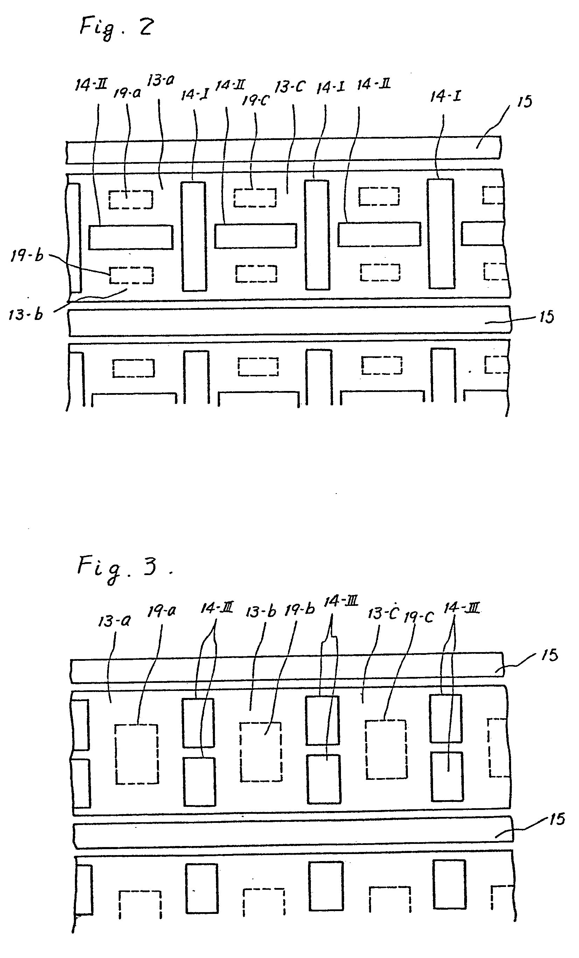

Figure 2 and Figure 3 illustrate further transistor structures for assistance in explanation of embodiments of this invention in which, in comparison with Fig. 1, the forms of isolation regions disposed within a stripe emitter region differ from that of the transistor structure of Fig. 1.

In the structure of Fig. 2, stripe emitter region 13 is isolated, separated, into a plurality of small emitter regions 13a, 13b, ..., in a matrix arrangement, by isolation regions 14-I disposed in directions orthogonal to the stripe direction and by isolation regions 14-II disposed in directions parallel to the stripe direction. The small emitter regions have a rectangular shape.

Each of the isolated small emitter regions allows the disposition of an emitter lead-out electrode connecting window 19a, 19b, ..., on the insulating film covering the surface of that region. The region 15 is a $P^+$ type base contact region as already explained with reference to Fig. 1.

In the structure of Fig. 3, the stripe emitter region 13 is isolated into a plurality of small emitter regions 13a, 13b, ..., by isolation regions 14-III which are disposed in directions orthogonal to the stripe direction. As compared with Fig. 1 it is as if each isolation region has been separated into two regions. Each of the isolated small emitter regions allows the disposition of an emitter lead-out electrode connecting window 19a, 19b, ..., on the insulating film covering the surface of the region.

In this structure, the small emitter regions 13a, 13b, ..., in the stripe emitter region 13 are isolated by cross-section reduction to the sides of the isolation regions 14-III and also below the isolation regions 14-III (i.e. reduced in depth).

The region 15 is the $P^+$ type base contact region.

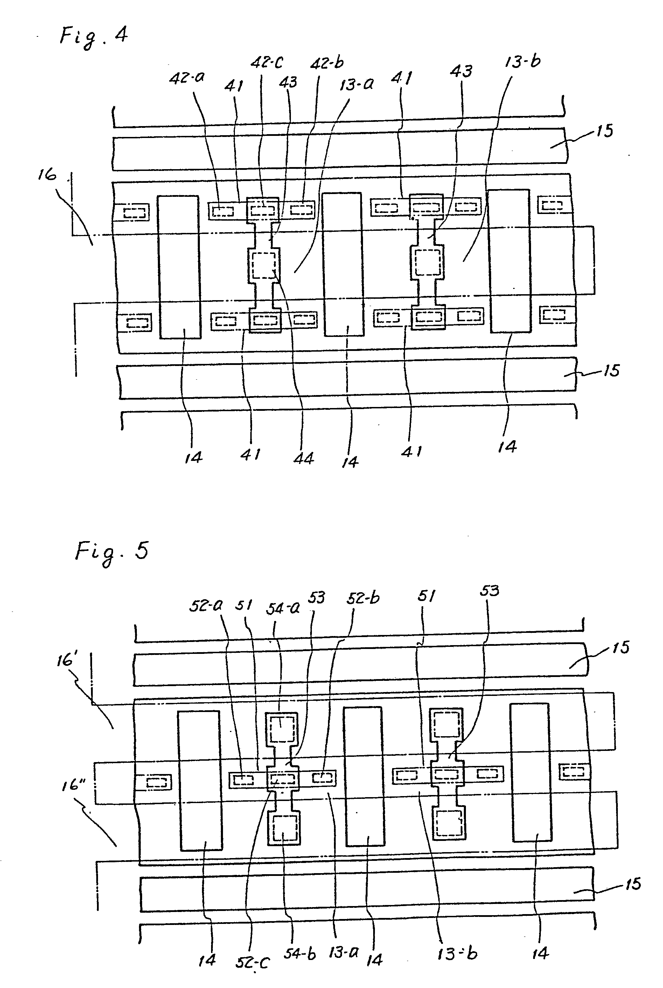

Figure 4 and Figure 5 illustrate the structures of transistors embodying the present invention, having forms generally similar to those of Figs. 1 to 3, wherein stabilizing resistors are inserted between the small emitter regions formed in a stripe emitter region and the relevant emitter lead-out electrode. In Fig. 4 and Fig. 5, isolation regions are inserted in accordance with the structure shown in Fig. 1 above.

In the structure shown in Fig. 4, emitter lead-out electrodes 16 (one is shown in Fig. 4) are disposed to extend generally along the center lines of the stripe emitter regions 13 (one is shown in Fig. 4) in the direction of the stripe, and electrically conductive, metallic wiring (or electrode) layers 41 are disposed in parallel to the emitter lead-out electrodes 16 on opposite sides of the emitter lead-out electrode 16, on each of the small emitter regions 13a, 13b etc. Metallic wiring layers 41 are connected to a small emitter region (for example, 13a) via connecting windows 42a, 42b provided in the insulating film over the emitter region (see film 18 in Fig. 1) while the metallic wiring layers 41 are connected to the emitter lead-out electrode 16 concerned for example via a $P^+$ type region (i.e. opposite conductivity type to that of the emitter region) constituting stabilizing resistor 43 as indicated in the Figure. The stabilizing resistor 43 and the emitter lead-out electrode 16 are connected to one another via a connecting window 44, while the stabilizing resistor 43 and the metallic wiring layers 41 are connected via connecting windows 42c. In this structure, since, considering small emitter region 13a for example, an emitter current flows to the stabilizing resistor and emitter lead-out electrode from both ends of the two metallic wiring layers 41 connected thereto, at least emitter-base junction areas near the base contact regions 15 of a small emitter region operate equally.

In a case in which a stabilizing resistor is formed by an impurity injection region having a conductivity type opposite to that of the emitter region as mentioned above in a structure such that the stabilizing resistor is inserted between the emitter lead-out electrode 16 and a small emitter region, application of such structure into a stripe emitter region having a structure as shown in Fig. 2 is difficult to realize because of the existence of the isolation region 14-II.

Therefore, in the context of a structure as shown in Fig. 2 it is appropriate to insert a stabilizing resistor consisting of a resistor material, for example a polycrystalline semiconductor layer or a metallic layer (of nichrome for example) between the emitter lead-out electrode and metallic wiring layer which connects the stabilizing resistor to the small emitter region in order to connect the lead-out electrode and the metallic wiring layer in the form of the bridge on the insulating film on which the emitter lead-out electrode and the metallic wiring layer are themselves disposed.

Of course, in the structures shown in Fig. 1 and Fig. 3, stabilizing resistors consisting of polycrystalline semiconductor layers or metallic layers can also be used.

In the structure shown in Fig. 5, metallic wiring (or electrode) layers 51 are disposed on the small emitter regions generally along the center line thereof, in the direction of the stripe emitter region 13, and emitter lead-out electrodes 16', 16" are disposed in the stripe direction to opposite sides of the metallic wiring layers 51. Thus, in effect, two emitter lead-out electrodes cover one stripe emitter region. Metallic wiring layer 51 is connected to a small emitter region (13a, for example) via connecting windows 52a, 52b provided in the insulating film over the emitter region, while the metallic wiring layers 51 and emitter lead-out electrodes 16', 16" connected to one another by a $P^+$ type region constituting a stabilizing resistor 53 as shown in the Figure. The stabilizing resistor 53 and the emitter lead-out electrodes 16', 16" are connected *via* connecting windows 54a, 54b, while the stabilizing resistor 53 and the metallic wiring layer 51 are connected *via* connecting window 52c. In such a structure, since an emitter current flows to a stabilizing resistor and an emitter lead-out electrode from both ends of the metallic wiring layer disposed generally centrally of the small emitter region concerned, at least the emitter-base junction areas near the base contact regions 15 in a small emitter region operate equally. A pair of emitter lead-out electrodes are disposed in parallel over a small emitter region resulting in an increase of the effective cross section area. Therefore, a structure as shown in Fig. 5 can be very effective for obtaining a higher output power by connecting in parallel the plurality of small emitter regions.

Even in the structure illustrated in Fig. 5, the stabilizing resistor can be composed of a polycrystalline semiconductor layer or a metallic layer of nichrome as is explained previously.

In the structure illustrated in Fig. 5, one of the two emitter lead-out electrodes 16', 16" and a stabilizing resistor part connected thereto may be omitted in order to provide a structure design such that a small capacity of current flows through the small emitter regions.

As is explained in detail with reference to the above embodiments, according to this invention, a transistor structure which can process a high frequency signal and offer a higher output power can be structured by separating a stripe or strip-like emitter region into small emitter regions by disposition of (isolation) regions having an opposite conductivity type into the emitter region, and by connecting said small emitter regions in parallel *via* stabilizing resistors using emitter lead-out electrodes disposed on the stripe emitter region.

In such structures, at least the emitter lead-out electrodes connect in parallel the small emitter regions disposed and mutually isolated within the stripe emitter region.

Since the isolation regions are put in a floating condition (in use) and lie within the emitter region, a short between emitter and base does not occur even when pinholes exist in the insulating film separating emitter region and emitter lead out electrodes, thereby preventing reduction in manufacturing yield and deterioration of reliability due to the presence of such shorts.

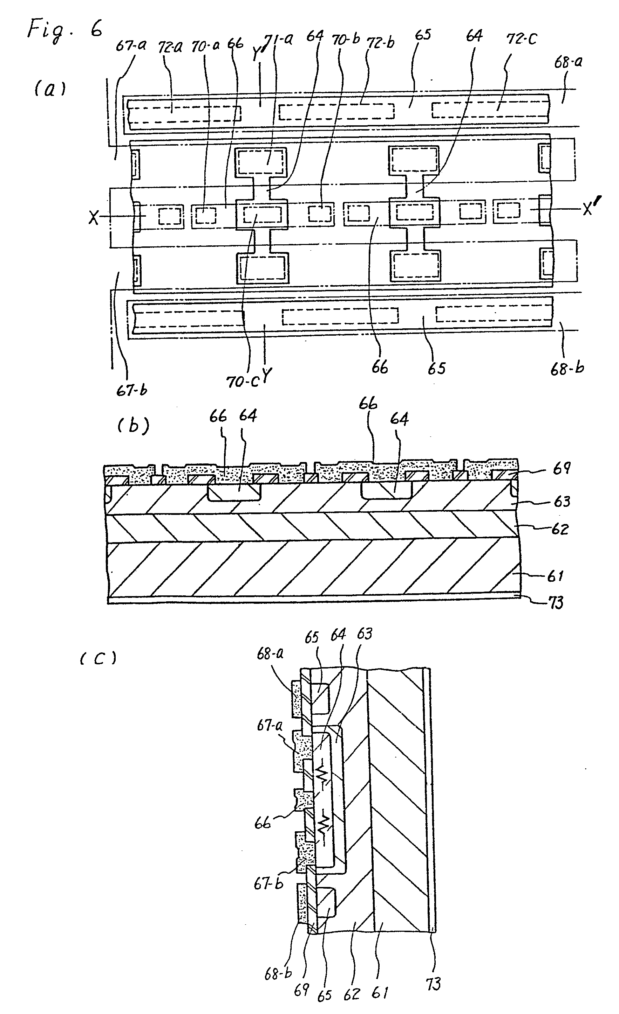

Figure 6 illustrates another transistor structure embodying this invention.

In this Figure, (a) is a plan view of the structure, (b) is a cross-sectional view taken along the line X—X' of (a), and (c) is a cross-sectional view taken along the line Y—Y' of (a).

In Fig. 6, 61 is a collector region having a structure for example comprising an N type epitaxial layer formed on an $N^+$ type semiconductor substrate, for example, a silicon substrate. 62 is a P type base region formed on the collector region 61. 63 is an $N^+$ type emitter region which is a stripe or strip-like, formed within the base region 62. 64 is a $P^+$ type region constituting a stabilizing resistor formed within said emitter region 63. 65 is a $P^+$ type base contact region. The base contact region 65 is formed in the base region 62 and extends alongside the stripe emitter region 63.

In addition, 66 is a metallic wiring (or electrode) layer which connects a stabilizing resistor region 64 and an emitter region 63; 67a, 67b are emitter lead-out electrodes; and 68a, 68b are base lead-out electrodes.

69 is an insulating film covering a semiconductor substrate surface; 70a, 70b and 70c are windows through which metallic electrode layers 66 formed on the insulating film 69 are connected to stabilizing resistors 64 and emitter regions 63; 71a, 71b are emitter lead-out electrode windows formed through the insulating film 69; 72a, 72b, ..., are base lead-out electrode connecting windows formed through the insulating film 69 and 73 is the collector electrode.

A transistor having a structure as illustrated in Figure 6 has a stripe emitter region 63 which is separated into a plurality of isolated small active emitter regions by the $P^+$ type regions 64 which are structured to act as stabilizing resistors and are disposed in the emitter region selectively and extend in directions orthogonally crossing the emitter stripe direction. Thus, the isolation regions and stabilizing resistors which have been provided separately in the previous embodiments are integrated into one structure and the stripe emitter region 63 is isolated into several small emitter regions by means of the stabilizing resistors 64.

The stabilizing resistors 64 are disposed in the form of lands in the stripe emitter region 63 as best seen in (c) and the cross section of the emitter region is reduced to the sides of the regions 64 (as seen in (a) and (c)) and is reduced in depth below the stabilizing resistors 64, going along a stripe emitter region in the stripe direction and thereby the stripe emitter region 63 is divided into a plurality of small isolated emitter regions due to increase of resistance value in the emitter region where the cross section thereof is reduced or constricted.

The separate small emitter regions respectively operate at the emitter-base junction areas near the adjacent base contact regions 65.

Thus, a single stripe emitter region 63 is effectively composed of plurality of small emitter regions connected in parallel by the emitter lead-out electrodes. A transistor having a structure as illustrated in Fig. 6 is suitable for high frequency signal operation and higher output power operation as in the case of the previous embodiments when stripe emitter regions are themselves connected in parallel.

In the case of the structure of Fig. 6, the emitter lead-out electrodes 67 connect in parallel the small emitter regions without being disposed on the base region. Therefore, even if an emitter lead-out electrode 67 is inadvertently connected to the stabilizing resistor 64 due to existence of pinholes in the insulating film separating electrode 67 and resistor 64, short circuits can occur only between the stabilizing resistor 64 and the emitter region and cannot lead to a short between the emitter region and the base region since a stabilizing resistor 64 is isolated and insulated from the base region by the emitter region itself and is put in a floating condition from the electrical viewpoint.

For this reason, reduction in manufacturing yield and deterioration of reliability cannot arise due to pinholes etc. in the insulating film under the emitter lead-out electrode.

The stabilizing resistor 64 can be formed by diffusion simultaneously with formation of the base contact region, whereby the number of manufacturing steps required is not increased. In addition, in the structure of Figure 6, a stabilizing resistor also functions as an isolation region, and therefore the integration density of a transistor unit so structured can be increased at least as compared with units structured in accordance with Fig. 4 or Fig. 5.

In an alternative structure, the metallic electrode layers 66 and emitter lead-out electrodes 67 as shown in Fig. 6 may be alternatively formed as illustrated in Fig. 4. That is, one emitter lead-out electrode 67 may be disposed along the center line of an emitter stripe extending in the stripe direction, with metallic electrode layers 66 disposed in parallel to the emitter lead-out electrode 67, on either side thereof.

Moreover, in the above described embodiments of this invention, small active emitter regions are defined in a stripe emitter region and the isolation regions and/or stabilizing resistors are disposed selectively to define those small active emitter regions.

This invention can also be applied in a transistor structure as follows.

In the case of a transistor structure wherein a plurality of stripe emitter regions are themselves connected in parallel electrically as mentioned previously, adjacent ends of the respective stripe emitter regions may be integrated by means of a region having a conductivity type the same as that of said emitter regions to provide for such parallel connection.

A lead wire connecting part, for external lead-out of the transistor, a so called bonding pad, can be disposed on the region which provides the parallel connection.

Such a bonding pad arrangement is employed to eliminate the possibility of shorts between the emitter electrodes and the base regions under the insulating film arising as a result of the existence of pinholes in the insulating film under the bonding pad or as a result of cracks generated when connecting lead wires.

However, the region having a conductivity type the same as that of the emitter regions for integrating the emitter regions in the area under the bonding pad can cause generation of a parasitic transistor unit in the region under the bonding pad and also result in deterioration of breakdown voltage of the transistor.

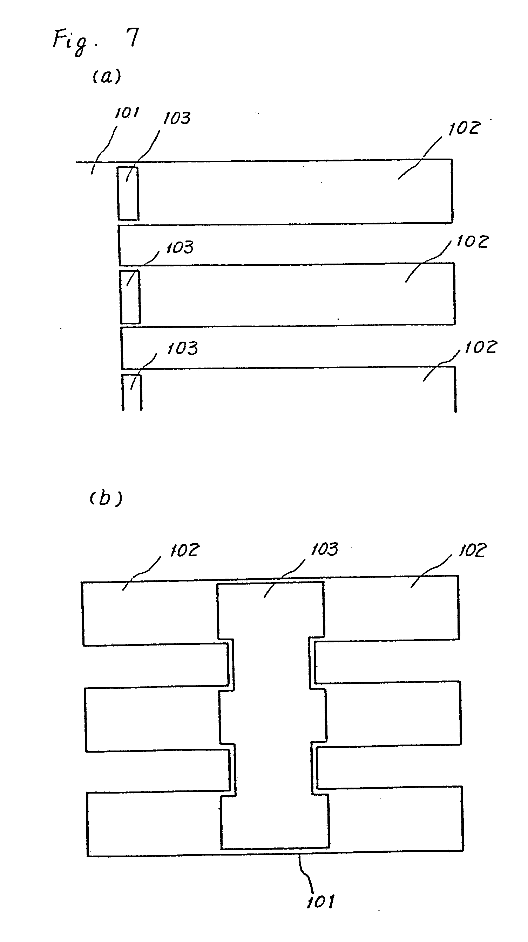

In order to avoid the problem of generation of a parasitic transistor unit whilst still providing for formation of a bonding pad over a region of the same conductivity type as the emitter, to eliminate the possibility of shorts between the bonding pad and a base region, a structure as illustrated in Fig. 7(a) can be used. In Fig. 7(a) stripe emitter regions are integrated with a region 101 which lies under a bonding pad (not shown). Near the connection areas between each stripe emitter region 102 and region 101 isolation regions 103 having a conductivity type opposite to that of the emitter regions are disposed. Each stripe emitter region is thus permitted to operate independently and the region 101 under the bonding pad becomes inactive electrically, thus suppressing and preventing parasitic transistor operation.

In Figure 7(b) a structure is shown in which stripe emitter regions 102 extend from either side of an integrating region 101 (over which a bonding pad is formed). A single isolation region 103 having opposite conductivity type to that of the emitter region is formed to take up almost all the area of the region 101 including areas adjacent to the areas of the region 101 which connect to the stripe emitter regions. Generation of parasitic transistor operation due to pinholes or cracks in the insulating film and shorts between the emitter electrode and base region can be prevented reliably by this structure when the bonding pad is formed on the region 101 over the insulating film.

The use of isolation regions in the nodes connecting a region under the bonding pad to stripe emitter regions of source can be adopted to the embodiments of this invention shown in Fig. 1 to Fig. 6 of course.

In other embodiments of this invention, a stabilizing resistor can be adopted as an isolation region which isolates a stripe emitter region from a region under a bonding pad which connects in parallel a plurality of such stripe emitter regions. Such a structure provides for the simultaneous separation of the stripe emitter regions and insertion of stabilizing resistors.

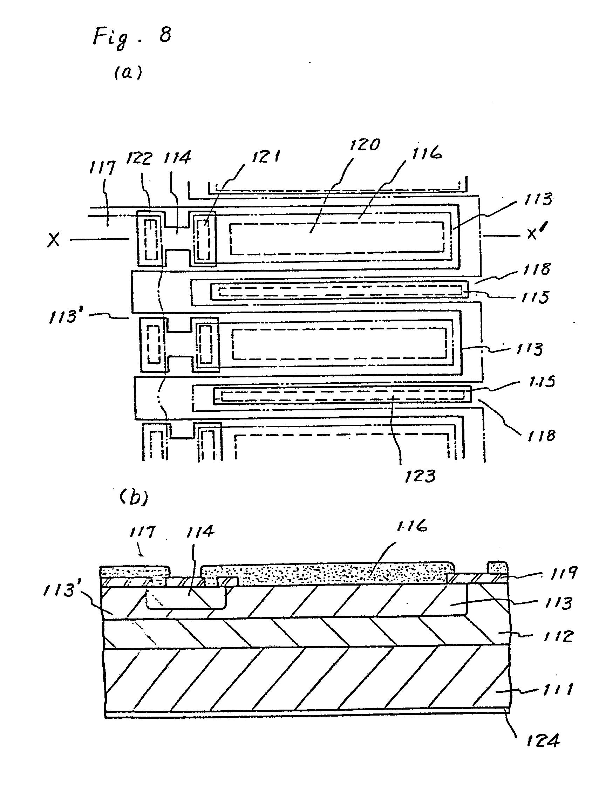

Figure 8 illustrates such a transistor structure. In Figure 8, (a) is a plan view of the transistor structure and (b) is a cross-sectional view taken along the line X—X' in (a).

In Figure 8, 111 is a collector region having a structure such that an N type epitaxial layer is formed, for example, on an N+ type semiconductor substrate; 112 is a P type base region formed on the collector region; 113 is an N+ type stripe emitter region formed in the base region 112; 113' is an N+ type region, under a bonding pad, which connects in parallel a number of emitter regions 113; 114 is a P+ type region constituting a stabilizing resistor; and 115 is a P+ type base contact region.

116 is an emitter electrode; 117 is an emitter lead-out electrode forming a bonding pad; and 118 is a base lead-out electrode.

119 is an insulating film covering the semiconductor substrate surface; 120 is an emitter electrode connecting window formed in the insulating film 119; 121 is a connecting window for connecting the emitter electrode 116 to the stabilizing resistor 114, which window is formed in the insulating film 119; 122 is an emitter lead out electrode connecting window formed in the insulating film 119; and 123 is a base lead-out electrode connecting window formed in the insulating film 119. 124 is a collector electrode.

In such a structure, a stripe emitter region 113 is connected to the emitter lead-out electrode 117 via a stabilizing resistor and is isolated from region 113' under the bonding pad by that stabilizing resistor.

Therefore, in the transistor structure of Fig. 8, each stripe emitter region 113 can operate individually without causing a concentration of a current, and the region 113' under the bonding pad is rendered inactive electrically. Thereby, the transistor structure of Figure 8 can therefore operate without deterioration in the current amplification factor.

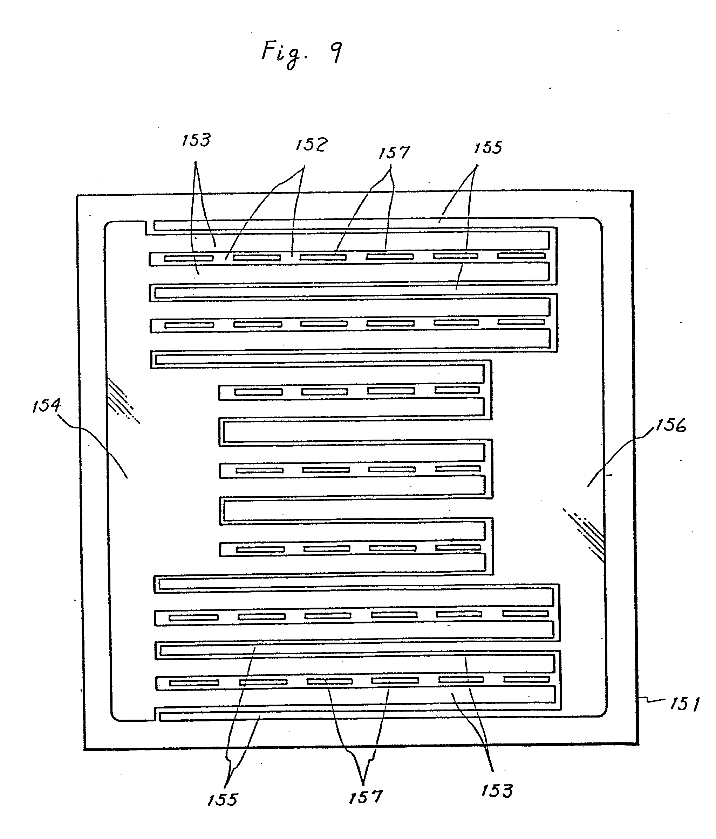

Figure 9 is a plan view of a transistor chip accommodating transistor unit structures as illustrated in Fig. 6.

In Figure 9, 151 is, for example a part of a transistor chip; 152 is an individual transistor unit. 153 is an emitter lead-out electrode; 154 is an emitter electrode terminal pad; 155 is a base lead-out electrode; 156 is a base electrode terminal pad; and 157 is a metallic wiring (or electrode) layer.

In Figure 9 said stabilizing resistors are not shown.

In the transistor structures described above a base contact region is indicated to have an elongate rectangular shape and to be disposed alongside the full length of a stripe emitter region. Alternatively, of course a base contact region can take the shape of land (e.g. that region need not extend the full length of a stripe emitter region) and a base lead-out electrode connecting window can alternatively be formed along the full length of the base contact region.

The following means can be employed in the formation of transistor structures as described with reference to Figures 2 to 9.

A collector region constituted by an N type layer on an N+ type semiconductor substrate can be formed by epitaxial growth of an N type layer on an N+ type semiconductor substrate by a conventional method, or by a process in which a high concentration of a donor impurity such as phosphorus (P) is injected from both sides of the N type semiconductor substrate in order to form N+ type layers on both sides of the substrate, whereafter one of the N+ type layers is removed.

A P type base region can be formed by a conventional complete diffusion method or by a method involving selective diffusion of an acceptor impurity such as boron (B) for example. In this case, if a transistor is to be used for handling a high voltage, it should have a so-called mesa structure wherein the base-collector (BC) junction appears in a side of a piece of semiconductor chip. On the other hand if the transistor is to be used for handling a comparatively low voltage, it should have a so-called planar structure wherein the BC junction terminates at the surface of the collector region.

The base contact region can be formed by selective injection of acceptor impurity, as in the case of the base region, but with a higher concentration of impurity than that injected into the base region by the diffusion method.

Moreover, the N+ type emitter region can be formed by selectively injecting a high concentration of donor impurity such as arsenic (As), phosphorus (P) into the base region by a diffusion method.

On the other hand, the P+ type isolation regions and the P+ type regions constituting stabilizing resistors can be formed by selectively injecting a high concentration of acceptor impurity into the emitter region by a diffusion method. At this time, since a diffusion depth for the base contact region is not strictly specified, the base contact region can be formed simultaneously with the diffusion of the isolation regions and/or the stabilizing resistors which are specified as having a diffusion depth.

For the surface insulating film, silicon dioxide

(SiO$_2$) formed by a thermal oxidation method or by a gas phase growth method can be used. It is alternatively possible to combine silicone nitride (Si$_3$N$_4$) and phosphor-silicate glass (PSG).

The emitter lead-out electrode, base lead-out electrode and metallic electrode layers can be formed, for example, by vacuum evaporation of aluminium (Al) and photo-etching, and electrical connection to the various regions formed in the substrate (e.g. base contact region etc.) can be provided through electrode windows which are formed in the insulating film by photo-etching.

In the abovementioned transistor manufacturing means, if the emitter region is shallow when the isolation regions and stabilizing resistors are formed therein, the emitter region may be formed to an unnecessary depth due to the so-called emitter-dip effect. This can result in reduced emitter-base breakdown voltage and reduced emitter-collector breakdown voltage, and in addition it can become difficult to obtain a sufficient current amplification factor in some cases. In order to reduce the problems which can be caused by such an emitter dip effect, the following measures can be taken.

(1) Areas of the base regions under areas in which isolation regions and stabilizing resistors are to be formed, can, in advance, be selectively formed with extra depth, so that sufficient base width (depth) remains after the parts of the emitter regions corresponding to those areas have been "pushed out" by the emitter dip effect.

(2) Areas of the emitter region in which isolation regions and stabilizing resistors are to be formed can, in advance, be selectively formed with a low impurity concentration and with a shallow depth, so that the emitter dip is taken into account so that when the isolation regions and stabilizing resistors are formed the emitter dip level reached is a desired emitter depth. In effect the emitter dip effect is cancelled and compensated.

(3) After formation of the base region, mesa type etching can be carried out so that the semiconductor substrate in areas in which isolation regions and stabilizing resistors are to be formed is extruded or projecting.

Thereafter, the emitter diffusion is carried out so that emitter region areas shallower than emitter region areas formed simultaneously in a peripheral flat area (around an extruded, projecting or mesa area) are formed in the areas under the extruded areas. The emitter dip level reached when the isolation regions and stabilizing resistors are formed in the extruded area is thus taken into account in advance and the emitter dip effect is cancelled and compensated.

As explained in detail above, embodiments of this invention use a transistor structure in which a base region having a conductivity type opposite to that of a collector is formed on the collector and an emitter region having a conductivity type the same as the collector is formed in the base region. The emitter lead-out electrodes are disposed so as to extend over the emitter region and connect in parallel isolated small emitter regions via lead-out electrode connecting windows, thereby the emitter lead-out electrodes are capable of connecting in parallel the small emitter regions without having to be disposed over the base region. Therefore, even if pinholes exist on the insulating film and the emitter lead-out electrodes are connected through those pinholes to isolation regions, short circuits can occur only between the isolation regions and the emitter region and cannot lead to shorts between the emitter region and the base region since the isolation regions are insulated and isolated from the base region by the emitter region itself, and are put in a floating condition electrically. For this reason, reduced manufacturing yield and deterioration of reliability due to the pinholes in the insulating film under emitter lead-out electrodes do not occur.

Furthermore, an emitter lead-out electrode can be formed to cover almost the entire area of a single emitter region, increasing the effective cross section. Such a structure can be very effective for handling high output power by increasing the number of transistor units formed in a stripe emitter region.

Since isolation regions can be formed by a diffusion method simultaneously with the formation of stabilizing resistors and/or base contact region, the number of manufacturing steps needed is not increased.

As explained above, embodiments of this invention can offer a transistor having excellent electrical characteristics without reduction in manufacturing yield but requiring only the same number or fewer manufacturing steps by improving the isolation structure of each transistor unit, the structure forming stabilizing resistors in the transistor units, the structure for leading out emitter lead-out electrodes; and moreover the structure for forming the base contact region.

In the embodiments described above reference has been made to an NPN transistor as an example but, of course, this invention can be used to provide PNP transistors.

In addition, the shape of the stabilizing resistors is not limited to a shape having a constricted part as in the case of the illustrated embodiments. It is of course possible to have other shapes having no constricted parts so long as the desired resistance values can be obtained.

Thus, transistors embodying this invention have a structure suitable for high frequency and high output power operation. An emitter region of one conductivity type is formed in a base region of the opposite conductivity type which base region is in contact with a collector region also of the one conductivity type. The emitter region is divided into plurality of active emitter regions by isolation regions of the opposite conductivity type which are formed in the emitter region and these active emitter regions are connected in parallel by an emitter electrode or lead-out electrode. Stabilizing resistors constituted by regions of the opposite conductivity type, or by other resistor material are inserted and connected between active emitter regions and the emitter electrode or lead-out electrode.

## Claims

1. A transistor structure having a collector region (61) of a first conductivity type, a base region (62) of a second, opposite, conductivity type, an emitter zone (63) of the first conductivity type, and an additional region (64), of the second conductivity type formed in the emitter zone, with a stabilising resistor connected between an emitter lead-out electrode (67a, 67b) and an active emitter region, characterised in that the additional region (64) is used as the stabilising resistor and in that the additional region (64) is arranged to divide the emitter zone (63) into a plurality of active emitter regions that are isolated thereby from one another, due to resistance generated as a result of the reduction of the cross section of the emitter zone (63) by the additional region (64).

2. A transistor structure having a collector region (11) of a first conductivity type, a base region (12) of a second, opposite, conductivity type, an emitter zone (13) of the first conductivity type, and an additional region (14) of the second conductivity type formed in the emitter zone, with a stabilising resistor (43, 53) connected between an emitter lead-out electrode (16; 16', 16") and an active emitter region (13a, 13b), characterised in that the additional region (14) is arranged to divide the emitter zone (13) into a plurality of active emitter regions (13a, 13b) that are isolated thereby from one another due to resistance generated as a result of the reduction of the cross section of the emitter zone (13) by the additional region, and in that a respective stabilising resistor (43, 53) is provided in respect of each active emitter region (13a, 13b) each stabilising resistor (43, 53) being a further region (43, 53) provided in the relevant active emitter region (13a, 13b), or being provided on the relevant active emitter region (13a, 13b).

3. A transistor structure having a collector region (111) of a first conductivity type, a base region (112) of a second, opposite, conductivity type, a stripe-like emitter zone (113) of the first conductivity type, and a further zone (113'), of the first conductivity type, contiguous with the emitter zone (113), a stabilising resistor (114) being formed in the region linking the contiguous emitter zone (113) and further zone (113') and being connected between the stripe-like emitter zone (113) and an emitter lead-out electrode (117), characterised in that the stabilising resistor (114) consists of a region (114) of the second conductivity type, and is arranged to isolate the stripe-like emitter zone (113) from the contiguous further zone (113'), due to resistance generated as a result of the reduction, by the region (114), of the cross section of the region linking the emitter zone (113) and the further zone (113').

4. A transistor structure as claimed in claim 2, wherein each stabilising resistor comprises a layer of resistor material disposed over an active emitter region of the plurality.

5. A transistor structure as claimed in claim 4, wherein the resistor material is a metallic material or a polycrystalline semiconductor material.

6. A transistor structure as claimed in claim 2, wherein the respective stabilising resistors are provided by such further regions, of the second conductivity type, disposed in the respective active emitter regions of the plurality.

7. A transistor structure as claimed in any one of claims 1, 2 and 4 to 6, wherein the active emitter regions of the plurality are electrically connected in parallel by an emitter electrode layer which is disposed over the emitter zone.

8. A transistor structure as claimed in any one of claims 1, 2 and claims 4 to 7, wherein the emitter zone extends in the form of a stripe, and the additional region extends substantially orthogonally across the stripe, the structure further comprising a base contact region, formed within the base region, which extends alongside the stripe of the emitter zone, and a base electrode layer connected to the base contact region.

9. A transistor structure as claimed in any one of claims 1, 2 and 4 to 8, wherein each of the active emitter regions of the plurality, when viewed in plan, has a generally rectangular shape.

10. A transistor structure, as claimed in any one of claims 1, 2 and 4 to 9, wherein the active emitter regions of the plurality are disposed in the form of a matrix.

11. A transistor structure as claimed in claim 3, comprising a plurality of such stripe-like emitter zones, and a plurality of such stabilising resistors formed to isolate the respective stripe-like emitter zones from the further region.

12. A transistors structure as claimed in claim 11, wherein each stabilising resistor has one end thereof connected to an emitter electrode layer which is itself connected to a stripe-like emitter zone, and has the other end thereof connected to an emitter electrode lead-out layer.

13. A transistor structure as claimed in any one of claims 3, 11, 12 and 13, wherein the said further region is disposed under a bonding pad.

**Patentansprüche**

1. Transistorstruktur mit einem Kollektorbereich (61) von einer ersten Leitfähigkeitsart, einem Basisbereich (62) von einer zweiten, entgegengesetzten Leitfähigkeitsart, einer Emitterzone (63) von der ersten Leitfähigkeitsart und einem zusätzlichen Bereich (64) von der zweiten Leitfähigkeitsart, welcher in der Emitterzone gebildet ist, mit einem stabilisierenden Widerstand, der zwischen einer Emitteranschlußelektrode (67a, 67b) und einem aktiven Emitterbereich geschaltet ist, dadurch gekennzeichnet, daß der zusätzliche Bereich (64) als der stabilisierende Widerstand verwendet wird und daß der zusätzliche Bereich (64) so angeordnet ist, daß er die Emitterzone (63) in eine Mehrzahl von aktiven Emitterbereichen teilt, welche dadurch aufgrund des Widerstandes, der als Folge der Reduktion des Querschnittes der Emitterzone (63) durch den zusätzlichen Bereich (64) erzeugt wird, voneinander isoliert sind.

2. Transistorstruktur mit einem Kollektorbereich (11) von einer ersten Leitfähigkeitsart, einem Basisbereich (12) von einer zweiten, entgegengesetzten Leitfähigkeitsart, einer Emitterzone (13) von der ersten Leitfähigkeitsart, und einem zusätzlichen Bereich (14) von der zweiten Leitfähigkeitsart, welcher in der Emitterzone gebildet ist, mit einem stabilisierenden Widerstand (43, 53), welcher zwischen einer Emitteranschlußelektrode (16, 16', 16") und einem aktiven Emitterbereich (13a, 13b) geschaltet ist, dadurch gekennzeichnet, daß der zusätzliche Bereich (14) so angeordnet ist, daß die Emitterzone (13) in eine Mehrzahl von aktiven Emitterbereichen (13a, 13b) unterteilt ist, welche dadurch voneinander aufgrund des Widerstandes isoliert sind, welcher als Folge der Reduktion des Querschnittes der Emitterzone (13) durch den zusätzlichen Bereich erzeugt wird, und daß ein entsprechender stabilisierender Widerstand (43, 53) für jeden aktiven Emitterbereich (13a, 13b) vorgesehen ist, wobei jeder stabilisierende Widerstand (43, 53) ein weiterer Bereich (43, 53) ist, welcher in dem relevanten aktiven Emitterbereich (13a, 13b) oder auf dem relevanten aktiven Emitterbereich (13a, 13b) vorgesehen ist.

3. Transistorstruktur mit einem Kollektorbereich (111) von einer ersten Leitfähigkeitsart, einem Basisbereich (112) von einer zweiten, entgegengesetzten Leitfähigkeitsart, einer streifenförmigen Emitterzone (113) von der ersten Leitfähigkeitsart und einer weiteren Zone (113') von der ersten Leitfähigkeitsart, welche der Emitterzone (113) benachbart ist, einem stabilisierenden Widerstand (114), welcher in dem Bereich gebildet ist, der die benachbarte Emitterzone (113) und die weiter Zone (113') verbindet und zwischen der streifenförmigen Emitterzone (113) und einer Emitteranschlußelektrode (119) geschaltet ist, dadurch gekennzeichnet, daß der stabilisierende Widerstand (114) aus einem Bereich (114) von der zweiten Leitfähigkeitsart besteht und so angeordnet ist, daß die streifenförmige Emitterzone (113) von der benachbarten weiteren Zone (113') aufgrund des Widerstands isoliert ist, welche als Folge der Reduktion des Querschnitts des Bereichs, welcher die Emitterzone (113) und die weitere Zone (113') verbindet, durch den Bereich (114) erzeugt wird.

4. Transistorstruktur nach Anspruch 2, bei welcher jeder stabilisierende Widerstand eine Schicht aus Widerstandsmaterial umfaßt, welche über einem der mehreren aktiven Emitterbereiche angeordnet ist.

5. Transistorstruktur nach Anspruch 4, bei welcher das Widerstandsmaterial ein metallisches Material oder ein polykristallines Halbleitermaterial ist.

6. Transistorstruktur nach Anspruch 2, bei welcher die entsprechenden stabilisierenden Widerstände durch solche weiteren Bereich der zweiten Leitfähigkeitsart gebildet sind, welche in den entsprechenden der mehreren aktiven Emitterbereich angeordnet sind.

7. Transistorstruktur nach einem der Ansprüche 1, 2 und 4 bis 6, bei welcher mehrere aktive Emitterbereiche durch eine Emitterelektrodenschicht, welche über der Emitterzone angeordnet ist, parallel zueinander elektrisch verbunden sind.

8. Transistorstruktur nach einem der Ansprüche 1, 2 und nach Ansprüchen 4 bis 7, bei welcher die Emitterzone sich in Form eines Streifens erstreckt und der zusätzliche Bereich sich im wesentlichen rechtwinklig quer zu dem Streifen erstreckt, und welche einen Basiskontaktbereich umfaßt, der innerhalb des Basisbereiches ausgebildet ist, welcher sich längs dem Streifen der Emitterzone erstreckt, und eine Basiselektrodenschicht, welche mit dem Basiskontaktbereich verbunden ist.

9. Transistorstruktur nach einem der Ansprüche 1, 2 und 4 bis 8, bei welcher jeder der mehreren aktiven Bereiche in der Draufsicht eine im allgemeinen rechtwinklige Form hat.

10. Transistorstruktur nach einem der Ansprüche 1, 2 und 4 bis 9, bei welcher die mehreren aktiven Emitterbereiche in Form einer Matrix angeordnet sind.

11. Transistorstruktur nach Anspruch 3, mit einer Mehrzahl von streifenförmigen Emitterzonen und einer Mehrzahl von solchen stabilisierenden Widerständen, welche zur Isolierung der entsprechenden streifenförmigen Emitterzonen von dem weiteren Bereich gebildet sind.

12. Transistorstruktur nach Anspruch 11, bei welcher ein Ende jedes stabilisierenden Widerstands mit einer Emitterelektrodenschicht verbunden ist, welche ihrerseits mit einer streifenförmigen Emitterzone verbunden ist, und das andere Ende mit einer Emitteranschlußelektrodenschicht verbunden ist.

13. Transistorstruktur nach einem der Ansprüche 3, 11, 12 und 13, bei welcher der genannte weitere Bereich unter einem Verbindungsplättchen angeordnet ist.

## Revendications

1. Structure de transistor possédant une région de collecteur (61) d'un premier type de conductivité, une région de base (62) d'un deuxième type, opposé, de conductivité, une zone d'émetteur (63) du premier type de conductivité, et une région supplémentaire (64), du deuxième type de conductivité, formée dans la zone d'émetteur, une résistance de stabilisation étant connectée entre une électrode à fil de sortie d'émetteur (67a, 67b) et une région d'émetteur active, caractérisée en ce que la région supplémentaire (64) est utilisée comme résistance de stabilisation et en ce que la région supplémentaire (64) est destinée à diviser la zone d'émetteur (63) en plusieurs régions d'émetteur actives qui sont ainsi séparées les unes des autres, en raison de la résistance produite par suite de la réduction de la section droite de la zone d'émetteur (63) par la région supplémentaire (64).

2. Structure de transistor possédant une région de collecteur (11) d'un premier type de conductivité, une région de base (12) d'un deuxième type, opposé, de conductivité, une zone d'émetteur (13) du premier type de conductivité, et une région supplémentaire (14), du deuxième type de conductivité, formée dans la zone d'émetteur, une résistance de stabilisation (43, 53) étant connectée entre une électrode à fil de sortie d'émetteur (16; 16', 16") et une région d'émetteur active (13a, 13b), caractérisée en ce que la région supplémentaire (14) est destinée à diviser la zone d'émetteur (13) en plusieurs régions d'émetteur actives (13a, 13b) qui sont ainsi séparées les unes des autres à cause de la résistance produite par suite de la réduction de la section droite de la zone d'émetteur (13) par la région supplémentaire, et en ce qu'une résistance de stabilisation respective (43, 53) est prévue pour chaque région d'émetteur active (13a, 13b), chaque résistance de stabilisation (43, 53) étant une autre région (43, 53) disposée dans la région d'émetteur active considérée (13a, 13b), ou étant prévue sur la région d'émetteur active considérée (13a, 13b).

3. Structure de transistor possédant une région de collecteur (111) d'un premier type de conductivité, une région de base (112) d'un deuxième type, opposé, de conductivité, une zone d'émetteur en forme de bande (113) du premier type de conductivité, et une autre zone (113'), du premier type de conductivité, contiguë à la zone d'émetteur (113), une résistance de stabilisation (114) étant formée dans la région reliant la zone d'émetteur contiguë (113) et ladite autre zone (113') et étant connectée entre la zone d'émetteur en forme de bande (113) et une électrode à fil de sortie d'émetteur (117), caractérisée en ce que la résistance de stabilisation (114) consiste en une région (114) du deuxième type de conductivité et est destinée à séparer la zone d'émetteur en forme de bande (113) vis-à-vis de l'autre zone contiguë (113'), à cause de la résistance produite par suite de la réduction, par la région (114), de la section droite de la région reliant la zone d'émetteur (113) et l'autre zone (113').

4. Structure de transistor selon la revendication 2, où chaque résistance de stabilisation comprend une couche de matériau pour résistances disposée au-dessus d'une région d'émetteur active.

5. Structure de transistor selon la revendication 4, où le matériau pour résistances est un matériau métallique ou un matériau semi-conducteur polycristallin.

6. Structure de transistor selon la revendication 2, où les résistances de stabilisation respectives sont produites par ces autres régions, du deuxième type de conductivité, disposées dans les régions d'émetteur actives respectives.

7. Structure de transistor selon l'une quelconque des revendications 1, 2 et 4 à 6, où les régions d'émetteur actives sont électriquement connectées en parallèle par une couche d'électrode d'émetteur qui est disposée au-dessus de la zone d'émetteur.

8. Structure de transistor selon l'une quelconque des revendications 1, 2 et 4 à 7, où la zone d'émetteur se présente sous forme d'une bande, et la région supplémentaire est orientée de manière sensiblement perpendiculaire à la bande, la structure comprenant en outre une région de contact de base, formée à l'intérieur de la région de base, qui est orientée suivant la bande de la zone d'émetteur, et une couche d'électrode de base connectée à la région de contact de base.

9. Structure de transistor selon l'une quelconque des revendications 1, 2 et 4 à 8, où chacune des régions d'émetteur actives possède une forme sensiblement rectangulaire lorsqu'elle est considérée en vue de plan.

10. Structure de transistor selon l'une quelconque des revendications 1, 2 et 4 à 9, où les régions d'émetteur actives sont disposées en forme de matrice.

11. Structure de transistor selon la revendication 3, comprenant plusieurs semblables zones d'émetteur en forme de bande et plusieurs semblables résistances de stabilisation formées pour séparer les zones d'émetteur en forme de bande respectives vis-à-vis de ladite autre région.

12. Structure de transistor selon la revendication 11, où chaque résistance de stabilisation possède une extrémité connectée à une couche d'électrode d'émetteur qui est elle-même connectée à une zone d'émetteur en forme de bande, tandis que l'autre extrémité de la résistance de stabilisation est connectée à une couche à fil de sortie d'électrode d'émetteur.

13. Structure de transistor selon l'une quelconque des revendications 3, 11, 12 et 13, où ladite autre région est disposée sous un plot de liaisons.

Fig. 1

(a)

(b)

(c)

Fig. 2

Fig. 3.

Fig. 4

Fig. 5

Fig. 6

(a)

Labels: 67-a, 72-a, 70-a, 66, 71-a, 64, 70-b, 72-b, 65, 64, 72-c, 68-a, X, X', 67-b, 70-c, Y, 66, 65, 68-b

(b)

Labels: 66, 64, 66, 64, 69, 63, 62, 61, 73

(C)

Labels: 65, 64, 63, 68-a, 67-a, 66, 67-b, 68-b, 69, 65, 62, 61, 73

4

Fig. 7

(a)

(b)

Fig. 8

(a)

(b)

Fig. 9